# FASCICULE DE BREVET EUROPEEN

(11) **EP 1 618 226 B1**
(45) Date de publication et mention de la délivrance du brevet: **03.01.2007**
(21) Numéro de dépôt: 04742846.1
(22) Date de dépôt: 14.04.2004
(51) Int. Cl.: C23C 16/26, C23C 16/02, H01L 51/30, C01B 31/02

(54) **PROCEDE DE CROISSANCE DE NANOTUBES DE CARBONE**
KOHLENSTOFF-NANORÖHREN-WACHSTUMSVERFAHREN
CARBON NANOTUBE GROWTH METHOD

(30) Priorité: 17.04.2003 FR 0304830
(43) Date de publication de la demande: 25.01.2006
(73) Titulaire: CENTRE NATIONAL DE LA RECHERCHE SCIENTIFIQUE, 75794 Paris Cedex 16 (FR)
(72) Inventeur: BONNOT, Anne-Marie, 38240 Meylan (FR); BOUCHIAT, Vincent, 38330 Biviers (FR); FAUCHER, Marc, 38120 Saint Egrève (FR)
(74) Mandataire: de Beaumont, Michel
(86) Numéro de dépôt international: PCT/FR2004/050160
(87) Numéro de publication internationale: WO 2004/094690

(56) Documents cités:
- EP-A- 1 134 304
- EP-A- 1 291 890
- MARTY L ET AL: "Batch processing of nanometer-scale electrical circuitry based on in-situ grown single-walled carbon nanotubes" MICROELECTRONIC ENGINEERING, ELSEVIER PUBLISHERS BV., AMSTERDAM, NL, vol. 61-62, juillet 2002 (2002-07), pages 485-489, XP004360573 ISSN: 0167-9317 cité dans la demande
- JANG J W ET AL: "Metallic conductivity in bamboo-shaped multiwalled carbon nanotubes" SOLID STATE COMMUNICATIONS, 2002, ELSEVIER, USA, vol. 122, no. 11, 2002, pages 619-622, XP002266477 ISSN: 0038-1098
- LEE C J ET AL: "Growth and structure of carbon nanotubes produced by thermal chemical vapor deposition" CARBON, XX, XX, vol. 39, no. 12, octobre 2001 (2001-10), pages 1891-1896, XP004299758 ISSN: 0008-6223

## Description

La présente invention concerne le domaine des nanotubes de carbone. On entend par nanotubes de carbone, des tubes comprenant une paroi (nanotubes monoparois) ou plusieurs parois concentriques (nanotubes multiparois), chaque paroi étant formée par l'enroulement d'un plan de graphite.

Divers procédés ont été développés pour faire croître des nanotubes de carbone sur des substrats. La plupart de ces procédés utilisent comme départ de croissance des nanotubes de carbone des grains de catalyseurs de dimensions voisines de celles du diamètre des nanotubes.

Deux des inventeurs de la présente demande ont proposé dans un article paru dans Microelectronic Engineering, 2002, vol. 61-62, p485, Elsevier Science B.V., un procédé dans lequel des nanotubes de carbone sont obtenus par une technique de dépôt chimique en phase vapeur assisté par filament chaud. Le dépôt prend typiquement place dans une plage de températures de 700 à 900°C alors que le filament chaud est à une température de l'ordre de 1900 à 2100°C. Dans cet article, les auteurs exposent que si l'on dépose sur un substrat revêtu d'oxyde de silicium des plots comprenant une couche de titane d'une épaisseur de 50 nm revêtue d'une couche mince de cobalt, on obtient une croissance de nanotubes de carbone. Les figures montrent que cette croissance se produit principalement à partir des faces latérales desdits plots.

Dans des expériences ultérieures, les inventeurs ont montré que le diamètre et la structure (mono-paroi ou multi-paroi) des nanotubes dépendaient essentiellement de l'épaisseur de la couche de cobalt.

Le nombre de nanotubes croissant à partir des faces latérales présentait une densité limitée et l'obtention de nanotubes de diamètre relativement élevé (supérieur à 5 nm) présupposait le dépôt d'une couche de cobalt sensiblement de la même épaisseur.

Un objet de la présente invention est d'optimiser la croissance de nanotubes de carbone en choisissant un substrat adapté.

Un autre objet de la présente invention est de prévoir un tel procédé adapté à la formation de nanotubes de carbone sur la surface supérieure d'une couche mince.

Un autre objet de la présente invention est d'optimiser la croissance des nanotubes de carbone sur des pointes.

Pour atteindre ces objets, la présente invention prévoit un procédé de croissance de nanotubes de carbone sur un substrat par un procédé de dépôt chimique en phase vapeur assisté par filament chaud, consistant à déposer au préalable sur le substrat un bicouche de titane et de cobalt tel que l'épaisseur de la couche de titane est comprise entre 0,5 et 5 nm ; l'épaisseur de la couche de cobalt est comprise entre 0,25 et 10 nm ; et l'épaisseur de la couche de cobalt est comprise entre la moitié et le double de l'épaisseur de la couche de titane.

Selon un mode de réalisation de la présente invention, la couche de titane est formée sur la couche de cobalt.

Selon un mode de réalisation de la présente invention, le substrat est en silicium revêtu d'oxyde.

Selon un mode de réalisation de la présente invention, le substrat comprend au moins une pointe, d'où il résulte qu'un nanotube croît en s'écartant du substrat à partir du sommet de la pointe et que d'autres nanotubes croissent en s'étalant contre le substrat.

Selon un mode de réalisation de la présente invention, le procédé comprend l'étape consistant à sélectionner la somme des épaisseurs de titane et de cobalt en fonction du diamètre et de la structure recherchés pour les nanotubes.

Selon un mode de réalisation de la présente invention, le bicouche est de type cobalt/titane et est formé sur une couche épaisse de titane.

Selon un mode de réalisation de la présente invention, le bicouche est de type titane/cobalt et est revêtu d'une couche de titane d'une épaisseur supérieure à 20 nm, d'où il résulte que les nanotubes ne croissent qu'à partir de la surface latérale du bicouche.

La présente invention prévoit aussi un substrat portant des nanotubes de carbone revêtu d'un bicouche de titane et de cobalt tel que l'épaisseur de la couche de titane est comprise entre 0,5 et 5 nm ; l'épaisseur de la couche de cobalt est comprise entre 0,25 et 10 nm ; et l'épaisseur de la couche de cobalt est comprise entre la moitié et le double de l'épaisseur de la couche de titane.

Ces objets, caractéristiques et avantages, ainsi que d'autres de la présente invention seront exposés en détail dans la description suivante de modes de réalisation particuliers faite à titre non-limitatif en relation avec les figures jointes parmi lesquelles :
la figure 1 représente une structure de croissance de nanotubes de carbone selon l'art antérieur ;
les figures 2A et 2B représentent des structures de croissance de nanotubes de carbone selon la présente invention ;
la figure 3 représente une structure de croissance de nanotubes de carbone sur une pointe selon la présente invention ;
les figures 4A et 4B représentent des variantes de structures de croissance de nanotubes de carbone selon la présente invention ; et
la figure 5 représente un exemple d'agencement de couches servant de départ à la croissance de nanotubes de carbone selon la présente invention.

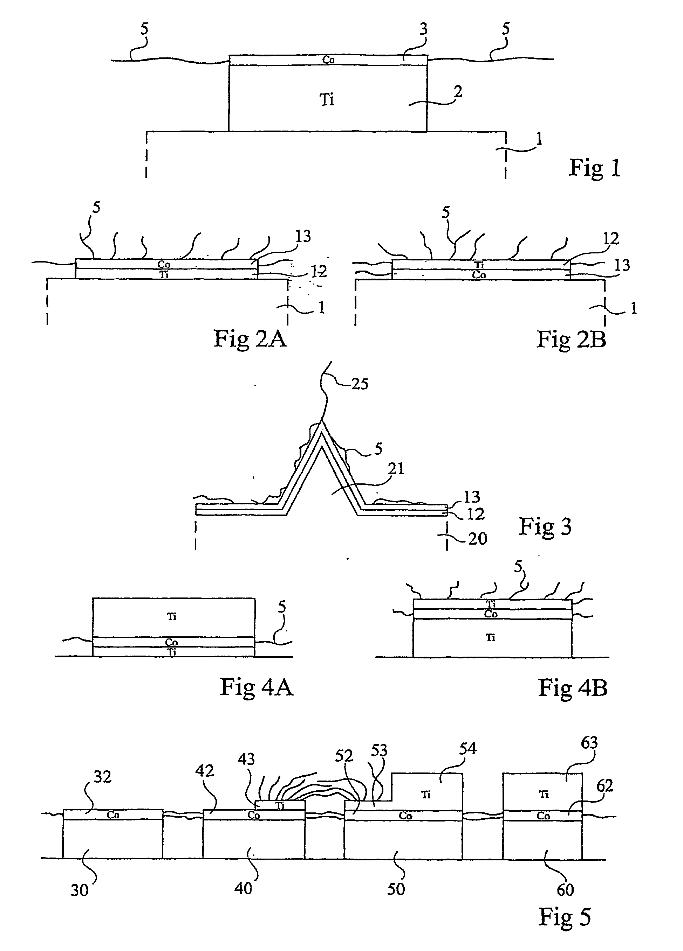

Comme l'illustre la figure 1, l'article susmentionné utilisait comme départ de croissance de nanotubes de carbone, sur un substrat revêtu d'une couche 1 de SiO₂, un plot constitué d'une portion de couche de titane 2 d'une épaisseur de l'ordre de 50 nm revêtue d'une couche mince 3 de cobalt.

La notion de plot n'est pas limitative et doit être interprétée comme désignant toute discontinuité d'épaisseur de couche délimitée selon un contour choisi.

Dans les conditions de dépôt indiquées précédemment, on obtenait comme cela est représenté schématiquement des nanotubes de carbone 5 croissant à partir des parois latérales du plot, sensiblement au niveau de la couche de cobalt.

La présente invention propose de remplacer la couche épaisse de titane (on entend ici par "épaisse" une couche d'une épaisseur supérieure à 10 à 20 nanomètres) par une couche très mince d'une épaisseur inférieure à 5 nm.

Plus particulièrement, l'épaisseur de la couche de titane est comprise entre 0,5 et 5 nm, l'épaisseur de la couche de cobalt est comprise entre 0,25 et 10 nm, et l'épaisseur de la couche de cobalt est comprise entre la moitié et le double de l'épaisseur de la couche de titane.

Comme l'illustre la figure 2A, la couche très mince de titane 12 peut être disposée sous la couche de cobalt 13 ou, comme l'illustre la figure 2, cette couche de titane 12 peut être disposée au-dessus de la couche de cobalt 13. Dans les deux cas, on obtient une croissance de nanotubes de carbone 5, dans les mêmes conditions de dépôt chimique en phase vapeur assisté par filament chaud que celles énoncées précédemment dans le cas de l'art antérieur, à la fois sur la face supérieure du bicouche et sur les faces latérales de ce bicouche. Il est clair pour l'homme de l'art que ces nanotubes sont représentés de façon extrêmement schématique pour indiquer les emplacements à partir desquels ils croissent mais que ces nanotubes seront de longueurs inégales et d'une densité qui peut être très supérieure à ce qui est représenté sur les figures.

Selon un avantage de la présente invention, le diamètre et la structure (mono-paroi, multi-paroi) de ces nanotubes seront sensiblement uniformes.

Selon une caractéristique de la présente invention, les inventeurs ont constaté expérimentalement que le diamètre et la structure des nanotubes dépendent non pas comme dans l'art antérieur de l'épaisseur de la seule couche de cobalt mais de l'épaisseur de l'ensemble des deux couches de titane et de cobalt. En outre, les inventeurs ont constaté que pour obtenir des nanotubes d'un diamètre donné, il suffisait que l'épaisseur totale du bicouche soit nettement inférieure à l'épaisseur totale d'une monocouche de cobalt fournissant le même résultat. Par exemple, pour un bicouche d'une épaisseur donnée, de l'ordre de 4 nm, on obtient des nanotubes de carbone d'un diamètre sensiblement identique à ce que l'on obtenait pour une monocouche de cobalt d'épaisseur double.

L'homme de l'art notera qu'il est avantageux d'obtenir des nanotubes de diamètre plus élevé à partir d'un dépôt plus mince étant donné que cela permet notamment de réaliser des dépôts sur des reliefs relativement tourmentés tout en conservant le relief, sans en arrondir les angles.

Un avantage de cette caractéristique apparaît dans la structure illustrée en figure 3 dans laquelle un substrat de silicium 20 muni d'une pointe pyramidale 21 est revêtu d'un bicouche titane-cobalt 12, 13 selon la présente invention. On constate alors que, si l'on effectue une croissance de nanotubes, un nanotube unique ou un fagot unique de nanotubes 25 se développe à partir de la pointe en s'écartant du substrat alors que, à partir du reste de la surface, des nanotubes 5 se développent mais restent collés au bicouche formé sur le substrat.

Selon un autre avantage de la présente invention, la densité des nanotubes de carbone obtenue est très supérieure à celle que l'on obtenait à partir d'un simple dépôt d'une couche de cobalt de même épaisseur que le bicouche.

D'autre part, comme l'illustrent les figures 4A et 4B, on peut selon la présente invention sélectionner les zones de croissance des nanotubes de carbone.

Par exemple, comme l'illustre la figure 4A, si l'on revêt un bicouche titane-cobalt selon la présente invention d'une couche épaisse (d'une épaisseur supérieure à 10 à 20 nm) de titane et que l'on structure la couche pour former un plot, on obtiendra seulement une croissance latérale de nanotubes 5.

Par contre, comme l'illustre la figure 4B, si l'on dépose sur une couche épaisse de titane un bicouche cobalttitane selon la présente invention, on obtiendra une croissance de nanotubes 5 à la fois sur la face supérieure et sur les faces latérales du bicouche.

La figure 5 présente uniquement à titre d'exemple un assemblage de plots permettant d'optimiser la croissance de nanotubes de carbone, par exemple pour former des liaisons entre plots. Quatre plots de titane épais (épaisseur supérieure à 10 à 20 nm) 30, 40, 50, 60 sont formés sur du silicium. Le plot 30 est recouvert d'une couche mince de cobalt 32. Le plot 40 est revêtu d'une couche mince de cobalt 42 partiellement revêtue d'une couche mince de titane 43. Le plot 50 est uniformément revêtu d'une couche de cobalt 52 revêtue partiellement d'une couche mince de titane 53 et partiellement d'une couche épaisse de titane 54. Le plot 60 est revêtu d'une couche mince de cobalt 62 et d'une couche de titane épaisse 63. Alors, on obtient des croissances de nanotubes de la façon illustrée schématiquement dans la figure : pour le plot 30, des nanotubes s'étendent seulement latéralement ; pour le plot 40, des nanotubes s'étendent latéralement, et en surface au-dessus de la portion de couche de titane 43 ; pour le plot 50, des nanotubes s'étendent latéralement, et en surface au-dessus de la région mince de titane 53 ; et pour le plot 60, des nanotubes s'étendent seulement latéralement à partir de la région de cobalt 62. Si on part de plots dont chacune des dimensions, en vue de dessus, est inférieure au micromètre, les nanotubes formés s'agglomèrent en un enchevêtrement de nanotubes (une tresse).

On voit les avantages de ce type de structure pour réaliser divers types de connexions et/ou de contacts, par exemple des connexions électriques. On notera que la présence d'une couche de titane permet d'obtenir une faible résistance d'accès au nanotube.

La présente invention vise un procédé de croissance optimisé de nanotubes de carbone et un substrat adapté. Les applications de ces nanotubes seront nombreuses comme cela est connu dans la technique et comme pourra l'imaginer l'homme de l'art en fonction des développements technologiques.

## Revendications

1. Procédé de croissance de nanotubes de carbone (5) sur un substrat (1) par un procédé de dépôt chimique en phase vapeur assisté par filament chaud, consistant à déposer au préalable sur le substrat un bicouche de titane (12) et de cobalt (13) tel que :
l'épaisseur de la couche de titane est comprise entre 0,5 et 5 nm ;
l'épaisseur de la couche de cobalt est comprise entre 0,25 et 10 nm ; et
l'épaisseur de la couche de cobalt est comprise entre la moitié et le double de l'épaisseur de la couche de titane.

2. Procédé selon la revendication 1, dans lequel la couche de titane est formée sur la couche de cobalt.

3. Procédé selon la revendication 1, **caractérisé en ce que** le substrat est en silicium revêtu d'oxyde.

4. Procédé selon la revendication 1, **caractérisé en ce que** le substrat comprend au moins une pointe (21), d'où il résulte qu'un nanotube (25) croît en s'écartant du substrat à partir du sommet de la pointe et que d'autres nanotubes croissent en s'étalant contre le substrat.

5. Procédé selon la revendication 1, comprenant l'étape consistant à sélectionner la somme des épaisseurs de titane et de cobalt en fonction du diamètre et de la structure recherchés pour les nanotubes.

6. Procédé selon la revendication 1, **caractérisé en ce que** le bicouche est de type cobalt/titane et est formé sur une couche épaisse de titane.

7. Procédé selon la revendication 1, **caractérisé en ce que** le bicouche est de type titane/cobalt et est revêtu d'une couche de titane d'une épaisseur supérieure à 20 nm, d'où il résulte que les nanotubes ne croissent qu'à partir de la surface latérale du bicouche.

8. Substrat portant des nanotubes de carbone (5), **caractérisé en ce qu'**il est revêtu d'un bicouche de titane (12) et de cobalt (13) tel que :
l'épaisseur de la couche de titane est comprise entre 0,5 et 5 nm ;
l'épaisseur de la couche de cobalt est comprise entre 0,25 et 10 nm ; et
l'épaisseur de la couche de cobalt est comprise entre la moitié et le double de l'épaisseur de la couche de titane.

9. Substrat selon la revendication 8, **caractérisé en ce qu'**il comprend des micropointes (21), d'où il résulte qu'un nanotube de carbone unique ou un unique fagot de nanotubes croît à partir de la pointe de chaque micropointe et que la croissance d'autres nanotubes se fait en s'étalant sur le substrat.

## Claims

1. A method for growing carbon nanotubes (5) on a substrate (1) by a hot-filament assisted chemical vapor deposition method, comprising the step of previously depositing on the substrate a titanium (12) and cobalt (13) bilayer such that
the thickness of the titanium layer ranges between 0.5 and 5 nm;
the thickness of the cobalt layer ranges between 0.25 and 10 nm; and
the thickness of the cobalt layer ranges between half and twice the thickness of the titanium layer.

2. The method of claim 1, wherein the titanium layer is formed on the cobalt layer.

3. The method of claim 1, **characterized in that** the substrate is made of silicon coated with oxide.

4. The method of claim 1, **characterized in that** the substrate comprises at least one tip (21), whereby a nanotube (25) grows by moving away from the substrate from the top of the tip and other nanotubes grow by spreading against the substrate.

5. The method of claim 1, comprising the step of selecting the sum of the titanium and cobalt thicknesses according to the diameter and to the structure wanted for the nanotubes.

6. The method of claim 1, **characterized in that** the bilayer is of cobalt/titanium type and is formed on a thick titanium layer.

7. The method of claim 1, **characterized in that** the bilayer is of titanium/cobalt type and is coated with a titanium layer of a thickness greater than 20 nm, whereby the nanotubes only grow from the lateral surface of the bilayer.

8. A substrate supporting carbon nanotubes (5), **characterized in that** it is coated with a titanium (12) and cobalt (13) bilayer such that:
the thickness of the titanium layer ranges between 0.5 and 5 nm;
the thickness of the cobalt layer ranges between 0.25 and 10 nm; and
the thickness of the cobalt layer ranges between half and twice the thickness of the titanium layer.

9. The substrate of claim 8, **characterized in that** it comprises microtips (21), whereby a single carbon nanotube or a single bundle of nanotubes grows from the tip of each microtip and the growth of other nanotubes is performed by spreading on the substrate.

## Patentansprüche

1. Verfahren zum Wachsen lassen von Kohlenstoff-Nanoröhren (5) auf einem Substrat (1) durch ein Heiz-Glühfaden-unterstütztes, chemisches Dampfabscheidungsverfahren, bei dem zunächst auf dem Substrat eine Doppelschicht aus Titan (12) und Kobalt (13) derart abgelagert wird, daß
die Dicke der Titanschicht zwischen 0,5 und 5 nm beträgt;
die Dicke der Kobaltschicht zwischen 0,25 und 10 nm beträgt; und
die Dicke der Kobaltschicht im Bereich zwischen der Hälfte und dem Doppelten der Dikke der Titanschicht liegt.

2. . Verfahren nach Anspruch 1, wobei die Titanschicht auf der Kobaltschicht ausgebildet ist

3. . Verfahren nach Anspruch 1, **dadurch gekennzeichnet, daß** das Substrat aus mit Oxid beschichtetem Silizium hergestellt ist

4. Verfahren nach Anspruch 1, **dadurch gekennzeichnet, daß** das Substrat wenigstens eine Spitze (21) umfaßt, wodurch eine Nanoröhre (25) wächst, indem sie sich von dem Gipfel der Spitze aus von dem Substrat wegbewegt, und weitere Nanoröhren wachsen, indexn sie sich gegen das Substrat ausbreiten

5. Verfahren nach Anspruch 1, mit dem Verfahrensschritt:
Auswählen der Summe der Dicken von Titan und Kobalt gemäß dem für die Nanoröhren gewünschten Durchmesser und der gewünschten Struktur

6. Verfahren nach Anspruch 1, **dadurch gekennzeichnet, daß** die Doppelschicht eine Kobalt/Iitan-Schicht ist und auf einer dicken Titanschicht ausgebildet ist

7. . Verfahren nach Anspruch 1, **dadurch gekennzeichnet, daß** die Doppelschicht eine Titan/Kobalt-Schicht ist und mit einer Titanschicht mit einer Dicke von mehr als 20 nm beschichtet ist, woraus folgt, daß die Nanoröhren nur ausgehend von der Seitenflächen der Doppelschicht wachsen

8. . Substrat zum Tragen von Koblenstoff-Nanoröhren (5), **dadurch gekennzeichnet, daß** es mit einer Doppelschicht aus Titan (12) und Kobalt (13) derart bedeckt ist, daß
die Dicke der Titanschicht zwischen 0,5 und 5 nm beträgt;
die Dicke der Kobaltschicht zwischen 0,25 und 10 nm beträgt; und
die Dicke der Kobaltschicht im Bereich zwischen der halben und der doppelten Dicke der Titanschicht liegt

9. Substrat nach Anspruch 8, **dadurch gekennzeichnet, daß** es Mikrospitzen (21) umfaßt, wobei eine einzelne Kohlenstoff-Nanolöhre oder ein einzelnes Bündel aus Kohlenstoff-Nanoröhren ausgehend von der Spitze jeder Mikrospitze wächst und das Wachstum anderer Nanoröhren durch Ausbreiten auf dem Substrat erfolgt
